Europäisches Patentamt

European Patent Office

Office européen des brevets

(19)

(11) Publication number: **0 334 827**
**A2**

(12) # EUROPEAN PATENT APPLICATION

(21) Application number: **89850097.0**

(51) Int. Cl.⁴: **H 05 K 13/04**

(22) Date of filing: **23.03.89**

(30) Priority: **24.03.88 NO 881316**

(43) Date of publication of application:
**27.09.89 Bulletin 89/39**

(84) Designated Contracting States:
**CH DE ES FR GB IT LI SE**

(71) Applicant: **Ersin, Mustafa**
**Björnebärstien 21**
**N-1349 Rykkin (NO)**

(72) Inventor: **Ersin, Mustafa**
**Björnebärstien 21**
**N-1349 Rykkin (NO)**

(74) Representative: **Wallin, Bo-Göran et al**
**AWAPATENT AB Box 5117**
**S-200 71 Malmö (SE)**

(54) **An apparatus for automatic assembly of components on a component carrier.**

(57) An apparatus for automatic assembly of components on a component carrier, such as a printed circuit board (9). The apparatus includes an automatic assembling machine (4) having a movable arm for gripping and assembly of components, and a number of component feeders (5). The automatic assembling machine (4) as well as the component carrier (9) are supported by a movable carrier means, e.g. a transportable carriage (1), which is arranged to be moved along the component feeders (5), for successive placing of the automatic assembling machine (4) and the component carrier (9) in an optimum position in relation to a desired component feeder (5), before carrying out the respective assembling operation.

FIG. 1

Bundesdruckerei Berlin

EP 0 334 827 A2

## Description

### An apparatus for automatic assembly of components on a component carrier

The present invention relates to an apparatus for automatic assembly of components on a component carrier, comprising an automatic assembling machine having at least one movable gripping arm for component assembly, a carrier means on which the automatic assembling machine and the topical component carrier are supported, to be movable along a path, and a means located alongside the path for the supply of components to the automatic assembling machine.

Such an apparatus is applied e.g. in the assembly of electrical components on printed circuit boards or the like, such printed circuit boards containing a large number of different components and a mechanized equipment for the assembly having to be used for both practical and economical reasons.

The automatic assembling machines or so-called robots utilized for such assembly, traditionally have been stationarily mounted and have a limited working range, the gripping arm or gripping arms of the robot being movable within a limited sector of a circle and having a limited radius of action. Out of considerations of space only a limited number of component feeders having a correspondingly limited number of components or component types can be placed within the working range, and in addition the assembly movements of the robot become relatively long so that the cycle time for the various assembling operations becomes relatively long.

An apparatus for automatic assembly of components on a printed circuit board, and which includes a stationary robot, is known from Swedish laying-open print No. 450 188. The object of this known apparatus is to achieve a positioning of the components on the circuit board which is as quick as possible, and in this connection to reduce the handling movement of the robot arm to a minimum. This is achieved in that the components are fed into the robot arm instead of displacing the robot arm forward to the feeding station for the components. For this purpose the apparatus is provided with feeding means or component feeders in the form of a hose or tube having the possibility to follow the movements of the robot arm gripper, and with means for feeding of the components to suitable gripping positions by means of air pressure. Thus, in this known apparatus, a reduced robot arm movement is achieved, but the robot is stationarily mounted and there is not achieved any extension of its actual working range.

An apparatus of the type stated in the introduction is known from US-patent specification No. 4 674 181 which discloses a working and assembling system wherein a robot is moved together with a working-assembling jig along an endless track in a closed loop. Along a portion of the loop track there is arranged a path of conveyance on which at least one tray with components is conveyed in synchronism with the robot, i.e. the tray follows the robot, the robot fetching workpieces or components on the tray and working/assembling these by using said jig in accordance with control instructions from a programmable control unit while the robot moves along the endless track. Along the endless track there are also arranged peripheral units for performing working operations which the robot is unable to perform, the peripheral units working in synchronism with the robot by means of said control unit. An important object of the known system is to make it possible to carry out the production of a large number of types of articles in small numbers with increased efficiency. This is achieved by moving several robots one after another along the closed loop track, and to allow the robots to make a complete circuit along the track without interfering with one another. The number of articles produced can be increased by increasing the number of robots, without increasing the number of said peripheral units, when the number of articles produced exceeds the capabilities of one robot. Thus, the known system is a combined working and assembling system, and is constructed for efficient automatic production of a large number of types of articles in small numbers.

A main object of the present invention is to provide an automatic apparatus for the assembly of components on printed circuit boards and the like, which gives the possibility of a practically unlimited increase of the working range of the automtaic assembling machine, at the same time as the cycle time is reduced.

Another object is to provide such an apparatus which has a great flexibility with respect to assembly pattern and component types, and which has a short readjustment time between different component-carrier products.

The above-mentioned objects are achieved by means of an apparatus of the introductorily stated type which, according to the invention, is characterized in that the means for the supply of components consists of a number of component feeders arranged for stationary placing in respective fixed positions along said path, and of which each provides for possible making-ready and feeding of a single component of a certain type to a definite supply postion, and that the carrier means is arranged to be moved along the number of component feeders, for successive placing of the automatic assembling machine together with the component carrier in a selected position in relation to a desired component feeder, for carrying out successive assembling operations.

The invention will be further described below in connection with exemplary embodiments with reference to the accompanying drawings, wherein

Fig. 1 shows a schematic plan view of a preferred embodiment of the apparatus according to the invention;

Fig. 2 shows an end view of an apparatus which essentially corresponds to the apparatus in Fig. 1; and

Fig. 3 shows a schematic plan view of another embodiment.

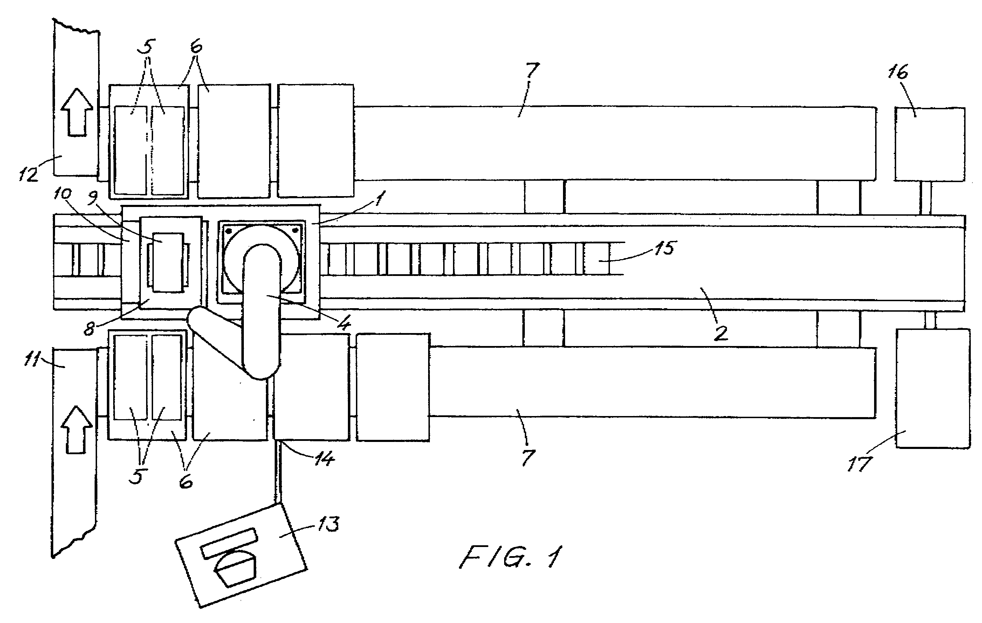

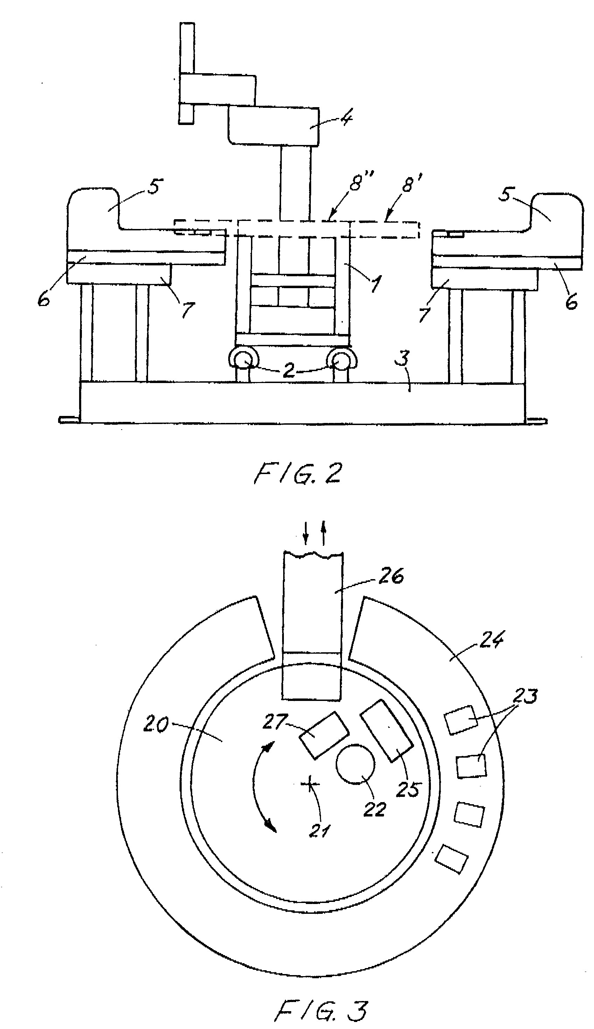

The apparatus shown in Figs. 1 and 2 is especially designed for the assembly of electronic components on printed circuit boards. However, it is clear that the apparatus could also be adapted for other types of component carriers and components. The apparatus includes a movable carrier means which, in the illustrated embodiment, is in the form of a carriage 1 which is transportable or movable on a driveway or track 2 on a base 3. An automatic assembling machine in the form of a robot 4 is stationarily mounted on the car riage 1. A number of feeding stations including per se known component feeders 5 which are placed on feeder modules 6, are arranged in a row on each side of the track or path 2. The feeder modules 6 also are of a per se known design and are placed on a module platform 7 and are connected through standard mechanical, pneumatic or electric connections (not further shown).

On the carriage 1 there is also arranged a holder or fixture 8 for the positioning and locking of printed circuit boards 9 in relation to the robot 4. The carriage is also equipped with a cutting and bending unit 10 for automatic cutting and bending of the connection pins or the like of the components. The unit is equipped with mechanical or electrical connection plugs and is easy to place in the carriage. At one end of the apparatus there is also arranged a mechanism 11, 12 for feeding-in and feeding-out of printed circuit boards. This mechanism may comprise an automatic circuit board loader.

The apparatus or plant is arranged to be programmed by means of a carriage 13 which is provided with programming equipment, such as a terminal, a video monitor, etc., and which is freely transportable on the floor along the plant. Along the driveway or path 2 there are arranged several plugs (not shown) for connection of the programming carriage 13 at different places 14.

As schematically shown in Fig. 1, the apparatus also includes electrical connection and control equipment in the form of cables 15, a junction box 16 and a control cabinet 17. Further details of the connecting arrangement are not shown, as such details are on the professional level.

The robot 4 used may be a commercially available, 4-axes robot, for instance of the type SCARA from Adept. It can be freely programmed in the space, and the control can be integrated with the visual system. The robot is constructed in such a manner that is starts and possibly completes the assembly movement of the gripping arm while the carriage 1 moves from one component feeder 5 to the next.

The driveway 2 suitably may consist of a servo-controlled shaft (not shown) which moves/positions the carriage 1. The carriage may be driven to any programmed position. Instead of a transportable carriage a conveyor belt or the like may be contemplated to be used.

In practice the feeder modules 6 consist of plates having locating holes and plugs. These holes and plugs correspond with corresponding plugs and holes existing in the module platform 7, so that when a module is placed on the module platform, it is interconnected with mechanical, pneumatic and/or electrical connections, as mentioned above. During operation one or more feeders are fitted on the module plate and made ready for the next production outside the assembly apparatus, without the production being stopped.

The circuit board fixture 8 is universal and is suitable for positioning and locking of different types of circuit boards. A suggested in Fig. 2, there may be arranged a pair of fixtures 8' and 8", a large fixture 8' suitable for larger circuit boards (up to a length of 50 cm), and a small fixture 8" for smaller circuit boards. Both fixtures are programmable and may easily be inserted into and removed from the carriage 1.

The apparatus operates in the following manner:

The carriage 1 at the outset will be located at the entrance end of the driveway 2, i.e. at the left end in Fig. 1. By means of the feeding-in mechanism 11 the topical printed circuit board 9 is positioned in the fixture 8 in front of the robot 4. While the circuit board is positioned, the robot will fetch a component from the first feeder 5. When the component has been gripped by the gripping arm of the robot, the circuit board will be in place, ready for assembly of the component. While the robot assembles the component on the circuit board, the carriage is moved and positioned in front of the next feeder which is to be used. The carriage is stopped in such a position that there will be a minimum distance between the component in the feeder and the place on the circuit board where the component is to be fitted. The robot may also be arranged to pick components successively while it is in movement, i.e. without stopping. In many cases the gripping arm of the robot will be finised with the assembly of the component and return to the fetching position for the next component before or at the same time as the carriage is positioned in front of the next feeder.

The assembly will continue in this manner until the assembly of all components belonging to the topical circuit board on one side of the driveway has been finished. When this has been done, the carriage will be moved backwards, and the robot will pick components from the feeders on the other side of the driveway and assemble or fit the components in the same manner. When the carriage returns to the intitial position, the robot will have finished the assembly of the last component.

As appears from the above, the basic principle of the apparatus is that the robot and the topical circuit board are placed in front of the respective feeders while the component is assembled. In this manner a constant distance from all feeders to the circuit board is achieved. Thereby a uniform and short cycle time is achieved. Another substantial advantage of this principle is that the number of feeders which can be connected in the system, is limited only by the length of the driveway or path. On a driveway with a length of 6 m there is room for approx. 40 feeding stations. From each feeding station 1-60 different components can be fed. This means that the apparatus can feed up to 2400 different components. If this is not sufficient, the movement path of the carriage, or generally of the carrier means, can be lengthened until the desired number of components is achieved.

The apparatus described above is based on a linear movement of the automatic assembling machine along an essentially horizontal path. Instead of a carriage or the like, which is movable along a horizontal path, there may also be contemplated a vertical movement by means of a suitable hoisting means transferring the automatic assembling machine and the component carrier along vertically disposed feeding stations.

One may also contemplate an embodiment wherein the carrier means is an integral part of an automatic handling machine arranged to move the carrier means (with assembling robot and circuit board or the like) along the topical path, i.e. along the row of component feeders. The apparatus e.g. may include a specially made robot having a rail means which extends a suitable length (e.g. 3 m) along the row or rows of component feeders which may be arranged as shown in Fig. 1. The rail means e.g. may comprise an upper and a lower pair of rails wherein the circuit board is displaceably mounted on the lower pair of rails, and a controllable arm, which is adapted to perform the necessary movements in connection with picking and assembling of components from the component feeders, is displaceably arranged on the upper pair of rails.

Another embodiment of the apparatus, which is based on a circular movement of the automatic assembling machine or robot, is schematically shown in Fig. 3. This embodiment includes an indexing table 20 which is rotatable about a center axis 21 and on which an automatic mounting machine or robot 20 is eccentrically mounted. The components are supplied from a number of component feeders 23 placed in an annular area 24 outside the indexing table 20. A holder for printed circuit boards 25 is arranged in front of the robot 22 on the indexing table. Circuit boards are supplied and delivered by means of a circuit board loader 26. A tool exchanging means 27 for the robot 22 is also shown on the indexing table. Such a means may also be provided in the embodiment according to Fig. 1.

During operation of this embodiment, the indexing table 20 is rotated step-by-step between the feeders 23, so that the robot 22 is brought to the desired optimum position opposite the desired feeder, to grip the topical component and assemble this on the board while the indexing table is rotated to the next feeding station. The apparatus according to this embodiment in principle functions in the same manner as the embodiment according to Figs. 1-2, and it may be provided with the same equipment with respect to operation and programming as the preceding embodiment.

The apparatus and the plant according to the invention as mentioned consist of programmable units. This implies that the apparatus can be readjusted from one product to another, i.e. in the shown embodiments for assembly of another circuit board configuration, in the course of few minutes, and without any mechanical readjustment. With other words, a great flexibility is achieved. The readjustment implies retrieval of the topical circuit board programme from a mass storage to the working storage of the apparatus and activation of this programme. This may be done manually or automatically, by means of a recognition or retrieval system and a softwear. The programme itself may be written and compiled in the programming carriage of the apparatus off-line, or on a personal computer (PC).

The apparatus may be provided with an interface giving the possibility for communication with other apparatuses and computers. As examples, there may be mentioned DAK interfaces, data networks and interfaces for retrieval systems for printed circuit boards (automatic activation of a programme). In that the apparatus can communicate with the majority of DAK systems, one has the possibility to load circuit board data automatically, simultaneously with a graphic off-line programming. By means of an intelligent softwear, also the programme of the cutting and bending unit of the apparatus may be generated automatically.

## Claims

1. An apparatus for automatic assembly of components on a component carrier (9, 25), comprising an automatic assembling machine (4; 22) having at least one movable gripping arm for component assembly, a carrier means (1; 20) on which the automatic assembling machine (4; 22) and the topical component carrier (9; 25) are supported, to be movable along a path (2), and a means (5; 23) located alongside the path (2) for the supply of components to the automatic assembling machine (4; 22), **CHARACTERIZED IN** that the means for the supply of components consists of a number of component feeders (5; 23) arranged for stationary placing in respective fixed positions along said path (2), and of which each provides for possible making-ready and feeding of a single component of a certain type to a definite supply position, and that the carrier means (1; 20) is arranged to be moved along the number of component feeders (5; 23), for successive placing of the automatic assembling machine (4; 22) together with the component carrier (9; 25) in a selected position in relation to a desired component feeder (5; 23), for carrying out successive assembling operations.

2. An apparatus according to claim 1, **CHARACTERIZED IN** that the automatic assembling machine (4; 22) is arranged to start and possibly complete the assembly movement of the gripping arm during the movement of the carrier means (1; 20) from one component feeder (5; 23) to the next one.

3. An apparatus according to claim 1, **CHARACTERIZED IN** that the path (2) is linear, the component feeders (5) being arranged in a row on at least one side of the linear path (2).

4. An apparatus according to claim 3, **CHARACTERIZED IN** that the carrier means is a transportable carriage (1) and the linear path (2) is substantially horizontal.

5. An apparatus according to claim 1, **CHAR-**

**ACTERIZED IN** that the carrier means is an indexing table (20) which is rotatable about a centre axis (21) and on which the automatic assembling machine (22) is eccentrically mounted, the component feeders (23) being arranged along a circular path (23) and being passed by the automatic assembling machine (22) and the component carrier (25) upon rotation of the table (20).

6. An apparatus according to any of the preceding claims, **CHARACTERIZED IN** that the carrier means (1) is arranged to support exchangeable fixtures (8', 8") for clamping of component carriers (9) of different sizes.

7. An apparatus according to any of the preceding claims, **CHARACTERIZED IN** that the component feeders (5) are disposed on feeder modules (6) arranged on a module platform (7) along said path (2).

8. An apparatus according to any of the preceding claims, wherein the automatic assembling machine is a programmable robot (4;

22), **CHARACTERIZED IN** that also the component feeders (5; 25) are programmable and are arranged to be programmed by means of a transportable programming carriage (13), and that several connection points (14) for the programming carriage (13) are arranged along said path (2).

9. An apparatus according to any of the preceding claims, wherein the component carrier (9) is a printed circuit board or the like for the assembly of electronic components provided with connection pins or the like, **CHARACTERIZED IN** that the carrier means (1) is provided with a unit (10) for automatic cutting and bending of the connection pins of the components after placing of the components on the circuit board (9).

10. An apparatus according to claim 9, **CHARACTERIZED IN** that it includes a programmable automatic circuit board loader (11, 12).

FIG. 1

EP 0 334 827 A2

FIG. 2

FIG. 3